(19) **Europäisches Patentamt**
**European Patent Office**
**Office européen des brevets**

(11) Veröffentlichungsnummer : **0 306 749 B1**

(12) **EUROPÄISCHE PATENTSCHRIFT**

(45) Veröffentlichungstag der Patentschrift :
14.08.91 Patentblatt 91/33

(51) Int. Cl.⁵ : **H05K 13/04, B23K 3/04**

(21) Anmeldenummer : **88113516.4**

(22) Anmeldetag : **19.08.88**

(54) **Elektrodenhalter für mindestens eine Bügelelektrode.**

(30) Priorität : **11.09.87 DE 3730647**

(43) Veröffentlichungstag der Anmeldung :
**15.03.89 Patentblatt 89/11**

(45) Bekanntmachung des Hinweises auf die
Patenterteilung :
**14.08.91 Patentblatt 91/33**

(84) Benannte Vertragsstaaten :
**AT BE CH DE FR GB IT LI NL SE**

(56) Entgegenhaltungen :
**DE-A- 3 149 236**
**FR-A- 2 388 626**

(73) Patentinhaber : **Siemens Aktiengesellschaft**
**Wittelsbacherplatz 2**
**W-8000 München 2 (DE)**

(72) Erfinder : **Hillebrand, Bernhard**
**Schanzenbachstrasse 10**
**W-8000 München 70 (DE)**

## Beschreibung

Die Erfindung betrifft einen Elektrodenhalter für die lösbare Anbringung und Stromversorgung mindestens einer Bügelelektrode, insbesondere für zwei oder mehrere Lötbügel.

Aus der DE-A-3149236 ist eine Schweißvorrichtung bekannt, deren Elektrodenhalter elektrisch voneinander isolierte, kleine Säulen aus leitfähigem Material umfaßt, zwischen deren Enden in auswechselbarer Weise mindestens zwei Bügelelektroden befestigt sind. Die U-förmigen Bügelelektroden, die aufgrund des Joule-Effektes erhitzt werden können, sind aus einer ebenen Platte hergestellt und in der Weise angebracht, daß sie mit ihrem randseitigen Schweißsteg in Kontakt mit den zu verschweißenden Elementen kommen. Bei einer Anzahl von zwei oder vier Bügelelektroden werden für den Elektrodenhalter insgesamt vier kleine Säulen benötigt, die auf einer jeweiligen Diagonale der Schweißvorrichtung angeordnet sind und durch mehrer kreuzförmige Verstrebungen mechanisch miteinander verbunden sind. Zur Stromversorgung von vier Bügelelektroden werden zwei auf einer Diagonale liegende kleine Säulen mit dem einen Pol einer Stromquelle verbunden, während die beiden anderen kleinen Säulen mit dem anderen Pol der Stromquelle verbunden werden.

Die bekannte Schweißvorrichtung und ähnlich aufgebaute Lötvorrichtungen werden für das Reflow-Löten hochpoliger Bauteile, insbesondere von SMD-Bauteilen wie Flatpack, Mikropack und dergleichen eingesetzt. Dabei wird der Elektrodenhalter der Vorrichtung derart abgesenkt, daß die jeweiligen Anschlüsse des Bauteils durch die Bügelelektrode mit den Enden der Leiterbahnen einer Leiterplatte oder eines Keramiksubstrats in Kontakt gehalten werden. Danach werden die Bügelelektroden mit Strom hoher Intensität gespeist, so daß die abgegebene Wärme die angestrebte Schweiß- oder Lötverbindung bewirkt. Nach Verfestigung des aufgeschmolzenen Materials wird der Elektrodenhalter dann wieder angehoben.

Der Erfindung liegt die Aufgabe zugrunde, einen insbesondere für die Anbringung mehrerer Bügelelektroden geeigneten Elektrodenhalter zu schaffen, der bei einfachem und kompaktem Aufbau eine hohe mechanische Stabilität aufweist.

Die Lösung dieser Aufgabe erfolgt bei einem gattungsgemäßen Elektrodenhalter durch einen Mittelteil und einen ringförmig geschlossenen, elektrisch isoliert und formschlüssig auf dem Mittelteil angeordneten Außenteil, wobei Mittelteil und Außenteil den Anschlüssen der Bügelelektroden zugeordnete Kontaktflächen aufweisen.

Der Erfindung liegt die Erkenntnis zugrunde, daß durch den Aufbau des Elektrodenhalters aus Mittelteil und ringförmig geschlossenem Außenteil eine äußerst kompakte und mechanisch stabile Bauform erzielt wird, die zudem noch die Stromversorgung von einer Bügelelektrode oder von mehreren Bügelelektroden erheblich vereinfacht. So braucht nur noch der Mittelteil an den einen Pol und der Außenteil an den anderen Pol einer Stromquelle angeschlossen zu werden, um mehreren Bügelelektroden den für die Erwärmung der Löt- oder Schweißstege erforderlichen Strom zuzuführen.

Gemäß einer bevorzugten Ausgestaltung der Erfindung weisen Mittelteil und Außenteil zumindest im Bereich der Kontaktflächen eine rechteckförmige oder quadratische Außenkontur auf. Eine derartige rechteckförmige oder quadratische Außenkontur ist auf die üblichen Bauformen der auf Leiterplatten oder Keramiksubstrate aufzulötenden elektronischen Bauteile abgestimmt, wobei zusätzlich auch noch die Anbringung der Bügelelektroden begünstigt wird. Eine weitere Abstimmung auf diese Bauformen der Bauteile bei gleichzeitiger Erhöhung der mechanischen Stabilität führt dann zu einer rechteckförmigen oder quadratischen Außenkontur des Mittelteils und einer rechteckförmigen oder quadratischen Innenkontur des Außenteils im Bereich des Formschlusses.

Schließlich hat es sich im Hinblick auf die angestrebte hohe Stabilität und die kompakte Bauweise des Elektrodenhalters als vorteilhaft erwiesen, wenn Mittelteil und Außenteil durch einen isolierenden Zweikomponenten-Klebstoff miteinander verbunden sind.

Ein Ausführungsbeispiel der Erfindung ist in der Zeichnung dargestellt und wird im folgenden näher beschrieben.

Es zeigen

Fig. 1    eine Seitenansicht eines für die Anbringung von zwei Flachlötbügeln bestimmten Elektrodenhalters,
Fig. 2    einen Längsschnitt durch den in Fig. 1 dargestellten Elektrodenhalter,
Fig. 3    einen Schnitt gemäß der Linie III-III der Fig. 2
Fig. 4    eine Seitenansicht eines für die Anbringung von zwei Blechlötbügeln bestimmten Elektrodenhalters und
Fig. 5    einen Längsschnitt durch den in Fig. 4 dargestellten Elektrodenhalter.

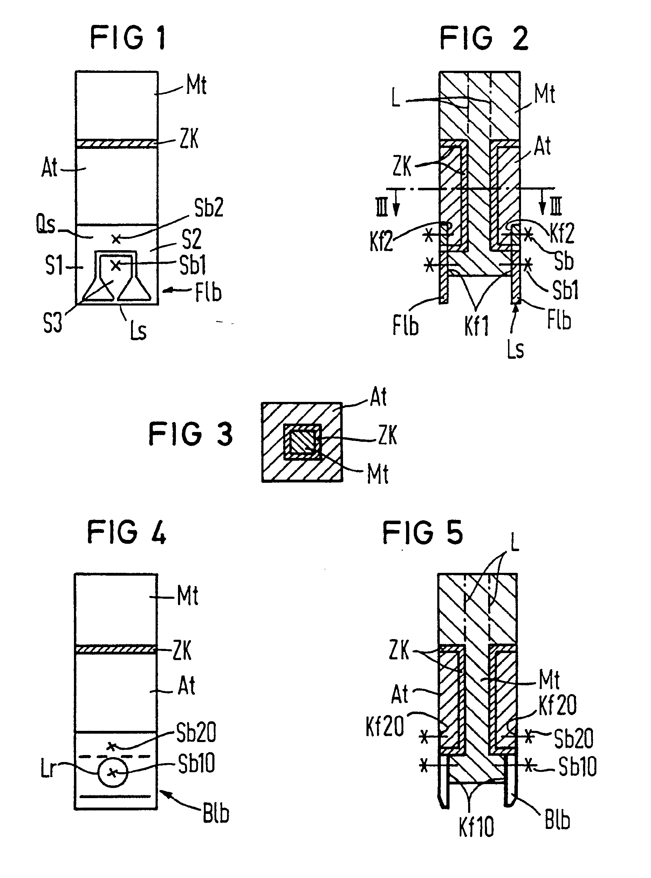

Die Fig. 1 und 2 zeigen in der Seitenansicht bzw. im Längsschnitt einen Elektrodenhalter mit zwei parallel und im Abstand zueinander daran befestigten Flachlötbügeln F1b. Jeder dieser Flachlötbügel F1b besteht aus

einem Lötsteg Ls, zwei äußeren Schenkeln S1 und S2, einem mittleren Schenkel S3 und einem sich zwischen den äußeren Schenkeln S1 und S2 erstreckenden Quersteg Qs, wobei die Befestigung und Kontaktierung des mittleren Schenkels S3 und des Quersteges Qs durch lediglich schematisch angedeutete Schrauben Sb1 bzw. Sb2 vorgenommen ist. Jeder der Flachlötbügel F1b ist aus einer ebenen Platte herausgebildet, in welche zur Trennung der beiden äußeren Schenkel S1 und S2 sowie des Quersteges Qs einerseits und des mittleren Schenkels S3 andererseits ein Schlitz Sz durch Drahterosion eingebracht ist. Der Schlitz Sz besitzt dabei eine U-förmige Gestalt, wobei sich die freien Schenkel dieses U-förmigen Schlitzes Sz zum Lötsteg Ls in derart dreiecksförmig verbreitern, daß sich eine entsprechende Verbreiterung der beiden äußeren Schenkel S1 und S2 und des mittleren Schenkels S3 zum Quersteg Qs hin ergibt. Bei einer derartigen Ausgestaltung des Flachlötbügels F1b mit einem Quersteg Qs wird auch bei unterschiedlichen Übergangswiderständen der durch die Schrauben Sb1 und Sb2 bewirkten Kontaktierungen eine gleichmäßige Strom-und Wärmeverteilung im Bereich des Lötsteges Ls erzielt. Außerdem führt die durch den Quersteg Qs geschlossene Form des Flachlötbügels F1b zu einer sehr hohen Eigenstabilität.

Der Elektrodenhalter besteht aus einem Mittelteil Mt und einem ringförmig geschlossenen und durch einen isolierenden Zweikomponenten-Klebstoff ZK elektrisch getrennt auf dem Mittelteil Mt angeordneten Außenteil At. Der Mittelteil Mt besitzt einen quadratischen Querschnitt, dessen mittlerer Bereich derart bemessen ist, daß der hier formschlüssig aufgesetzte Außenteil At die gleiche Außenkontur aufweisen kann, wie die übrigen Bereiche des Mittelteils Mt. Der Formschluß von Mittelteil Mt und Außenteil At bei gleichzeitiger mechanischer Verbindung und elektrischer Trennung durch den Zweikomponenten-Klebstoff ZK ist insbesondere aus dem Querschnitt gemäß Fig. 3 ersichtlich. In Fig. 2 ist durch zwei strichpunktierte Linien L angedeutet, daß der Mittelteil Mt ursprünglich aus zwei Teilen besteht, die nach dem Aufbringen des Außenteils At und vor dem Einbringen des Zweikomponenten-Klebstoffs ZK beispielsweise durch Löten miteinander verbunden werden.

Der aus dem Mittelteil Mt, dem Außenteil At und der durch den Zweikomponenten-Klebstoff ZK gebildeten dünnen Isolier- und Verbindungsschicht bestehende Elektrodenhalter besitzt im Bereich des unteren Endes des Mittelteils Mt zwei gegenüberliegende Kontaktflächen Kf1 und zwei plan dazu ausgerichtete einander gegenüberliegende Kontaktflächen Kf2 im Bereich des Außenteils At. Die Verbindung der Querstege Qs der Flachlötbügel F1b mit den Kontaktflächen Kf2 erfolgt durch die bereits erwähnten Schrauben Sb2, während die Verbindung der mittleren Schenkel S3 der Flachlötbügel F1b mit den Kontaktflächen Kf1 durch die ebenfalls bereits erwähnten Schrauben Sb1 erfolgt. Der Mittelteil Mt ist dabei im unteren Bereich an den Ecken derart abgeschrägt, daß die Breite der Kontaktflächen Kf1 der Breite der mittleren Schenkel S3 entspricht.

Als Materialien für den Mittelteil Mt und den Außenteil At sind beispielsweise hochfeste Kupferlegierungen geeignet, während als Materialien für die Flachlötbügel F1b beispielsweise Widerstandsmaterialien wie Molybdän oder Titan geeignet sind. Zur weiteren Verbesserung der Kontaktierung kann im Bereich der Kontaktflächen Kf1 und Kf2 zunächst eine etwa 1µm starke Nickelschicht und darauf eine ca. 0,5 µm starke Goldschicht aufgebracht werden.

Bei dem anhand der Fig. 1 bis 3 beschriebenen Elektrodenhalter einer Lötvorrichtung werden zwei parallel im Abstand zueinander ausgerichtete Flachlötbügel F1b eingesetzt, die zum Einlöten von Bauteilen mit zwei parallelen Reihen von Anschlüssen geeignet sind. Es ist zu erkennen, daß an dem Elektrodenhalter ohne weiteres auch vier Flachlötbügel angebracht werden können und daß selbst auch Ausführungsformen mit mehr als vier Lötbügeln möglich sind. Bei einem sechseckförmigen Querschnitt des Elektrodenhalters können beispielsweise sechs Flachlötbügel eingesetzt werden. Unabhängig von der Anzahl der am Elektrodenhalter angebrachten Flachlötbügel sind in jedem Fall nur noch zwei Stromzuführungen zum Elektrodenhalter erforderlich. Diese Stromzuführungen werden beispielsweise auf einfache Weise am Außenteil At und am Mittelteil Mt mittels Schrauben befestigt.

Die Fig. 4 und 5 zeigen in der Seitenansicht bzw. im Längsschnitt einen für die Anbringung von zwei gefalteten Blechlötbügeln B1b bestimmten Elektrodenhalter. Dabei sind die inneren Schenkel der U-förmigen Blechlötbügel B1b mittels Schrauben Sb10 an Kontaktflächen Kf10 des Mittelteils Mt befestigt, während die äußeren Schenkel mittels Schrauben Sb20 an Kontaktflächen Kf20 des Außenteils At befestigt sind. Im Unterschied zu dem anhand der Fig. 1 bis 3 dargestellten Ausführungsbeispiel sind die Kontaktflächen Kf10 des Mittelteils Mt gegenüber den Kontaktflächen Kf20 des Außenteils At um die Tiefe der Blechlötbügel B1b versetzt. Außerdem sind in die äußeren Schenkel der Blechlötbügel B1b Löcher Lr eingebracht, welche die Zugänglichkeit zu den Schrauben Sb10 ermöglichen. Im übrigen entsprechen Aufbau und Wirkungsweise des in den Fig. 4 und 5 dargestellten Elektrodenhalters dem bereits anhand der Fig. 1 bis 3 beschriebenen Elektrodenhalter.

## Patentansprüche

1. Elektrodenhalter für die lösbare Anbringung und Stromversorgung mindestens einer Bügelelektrode, insbesondere für zwei oder mehrere Lötbügel, **gekennzeichnet durch** einen Mittelteil (Mt) und einen ringförmig geschlossenen, elektrisch isoliert und formschlüssig auf dem Mittelteil (Mt) angeordneten Außenteil (At), wobei Mittelteil (Mt) und Außenteil (At) den Anschlüssen der Bügelelektroden (F1b ; B1b) zugeordnete Kontaktflächen (Kf1, Kf2 ; Kf10, Kf20) aufweisen.

2. Elektrodenhalter nach Anspruch 1, **dadurch gekennzeichnet,** daß Mittelteil (Mt) und Außenteil (At) zumindest im Bereich der Kontaktflächen (Kf1, Kf2 ; Kf10, Kf20) eine rechteckförmige oder quadratische Außenkontur aufweisen.

3. Elektrodenhalter nach Anspruch 1 oder 2, **gekennzeichnet durch** eine rechteckförmige oder quadratische Außenkontur des Mittelteils (Mt) und eine rechteckförmige oder quadratische Innenkontur des Außenteils (At) im Bereich des Formschlusses.

4. Elektrodenhalter nach einem der vorhergehenden Ansprüche, **dadurch gekennzeichnet,** daß Mittelteil (Mt) und Außenteil (At) durch einen isolierenden Zweikomponenten-Klebstoff (ZK) miteinander verbunden sind.

## Claims

1. Electrode holder for detachably mounting and supplying current to at least one stirrup electrode, preferably for two or more soldering stirrups, characterised by a middle part (Mt) and an annularly closed, electrically isolated outer part (At) arranged in a formfitting fashion on the middle part (Mt), the middle part (Mt) and outer part (At) having contact surfaces (Kf1, Kf2 ; Kf10, Kf20) allocated to the terminals of the stirrup electrodes (F1b; B1b).

2. Electrode holder according to Claim 1, characterised in that at least in the region of the contact surfaces (Kf1, Kf2 ; Kf10, Kf20) the middle part (Mt) and outer part (At) have a rectangular or square outer contour.

3. Electrode holder according to Claim 1 or 2, characterised by a rectangular or square outer contour of the middle part (Mt) and a rectangular or square inner contour of the outer part (At) in the region of the form fit.

4. Electrode holder according to one of the preceding claims, characterised in that the middle part (Mt) and outer part (At) are connected to one another by means of an insulating two-component adhesive (ZK).

## Revendications

1. Porte-électrode pour le montage amovible et l'alimentation en courant d'au moins une électrode en forme d'étrier, notamment pour deux ou un plus grand nombre d'étriers de brasage, caractérisé par une partie centrale (Mt) et une partie extérieure (At) fermée en forme annulaire et montées selon une liaison par formes complémentaires et d'une manière électriquement isolée sur la partie centrale (Mt), cette partie centrale (Mt) et la partie extérieure (At) possédant des surfaces de contact (Kf1, Kf2 ; Kf10, Kf20) associées aux bornes des électrodes (F1b ; B1b) en forme d'étrier.

2. Porte-électrode suivant la revendication 1, caractérisé par le fait que la partie centrale (Mt) et la partie extérieure (At) possèdent, au moins dans la zone des surfaces de contact (Kf1, Kf2 ; Kf10, Kf20), un contour extérieur rectangulaire ou carré.

3. Porte-électrode suivant la revendication 1 ou 2, caractérisé par un contour extérieur rectangulaire ou carré de la partie centrale (Mt) et un contour rectangulaire ou carré de la partie extérieure (At) dans la zone de la liaison par formes complémentaires.

4. Porte-électrode suivant l'une des revendications précédentes, caractérisé par le fait que la partie centrale (Mt) et la partie extérieure (At) sont reliées entre elles par une colle isolante à deux constituants (Zk).

# FIG 1

Mt
ZK
At
Qs
Sb2
S2
S1
Sb1
Flb
S3
Ls

# FIG 2

L
Mt
ZK
At
III III
Kf2
Kf2
Sb
Sb1
Flb
Kf1
Flb
Ls

# FIG 3

At
ZK
Mt

# FIG 4

Mt
ZK
At
Sb20
Lr
Sb10
Blb

# FIG 5

L
ZK
Mt
At
Kf20
Kf20
Sb20
Sb10
Blb
Kf10